# EUROPEAN PATENT SPECIFICATION

(11) **EP 0 714 556 B1**
(45) Date of publication and mention of the grant of the patent: **20.01.1999**
(21) Application number: 95915996.3
(22) Date of filing: 10.05.1995
(51) Int. Cl.: H01L 33/00, C08G 61/02, H01L 51/30

(54) **LIGHT-EMITTING DIODE COMPRISING AN ACTIVE LAYER OF 2,5-SUBSTITUTED POLY(P-PHENYLENE VINYLENE)**
LICHTEMITTIERENDE DIODE MIT EINER AKTIVEN SCHICHT AUS 2,5-SUBSTITUIERTEM POLY( P-PHENYLEN-VINYLEN)
DIODE A LUMINESCENCE COMPRENANT UNE COUCHE ACTIVE DE POLY(PHENYLENE-VINYLENE) SUBSTITUE EN POSITION 2 ET EN POSITION 5

(30) Priority: 19.05.1994 EP 94201419
(43) Date of publication of application: 05.06.1996
(73) Proprietor: Koninklijke Philips Electronics N.V., 5621 BA Eindhoven (NL)
(72) Inventor: STARING, Aemilianus, Gradus, Johannus, NL-5621 BA Eindhoven (NL); DEMANDT, Robert, Jozef, Catharina, Emiel, NL-5621 BA Eindhoven (NL)
(74) Representative: Stolk, Steven Adolph
(86) International application number: IB9500345
(87) International publication number: WO9532526

(56) References cited:
- EP-A- 443 861
- WO-A-92/16023
- STN INTERNATIONAL, File Caplus, Caplus accession no. 1990:620894, BURROUGHES, J.H. et al.: "Light-emitting diodes based on conjugated polymers", NATURE, (London), 1990, 347(6293), 539-41.

## Description

The invention relates to a light-emitting diode comprising an active layer which contains conjugated 2,5 dialkyl-substituted poly(p-phenylene vinylene) (PPV) and which layer is situated between two electrode layers, at least one of which is translucent. The invention also relates to novel, soluble, conjugated 2,5 dialkyl-substituted poly(p-phenylene vinylene) compounds. The invention further relates to a method of manufacturing an electroluminescent (EL) device, in particular a light-emitting diode (LED), in which use is made of such a conjugated polymer.

Solid-state LEDs have found widespread application, for example, in displays and indicator lamps. For the active or emissive layer in EL structures, use is generally made of traditional III-V semiconductor compounds, such as doped GaAs and GaP. The action is based on recombinations of electron-hole pairs which are injected into the semiconductor material from electrodes situated on either side of the active layer. By virtue of these recombinations, energy is released in the form of (visible) light; this phenomenon is commonly referred to as electroluminescence. The wavelength and hence the colour of the emitted light is determined by the band gap of the semiconductor material.

Using the known technologies in combination with the above-mentioned inorganic semiconductor materials, it is very difficult to manufacture large-area displays having dimensions of, for example, several centimetres. In addition, the available colours of the emitted light are limited to the long wavelength end of the visible spectrum.

The use of semiconductive organic polymers expands the number of materials which can be used in EL devices. Semiconductive organic polymers have a conjugated polymeric chain. The band gap, the electron affinity and the ionization potential can be adjusted by choosing the proper conjugated polymeric chains and suitable side chains. Unlike electroconductive polymers, these conjugated polymers are undoped. In addition, such polymers enable the use of flexible substrates. An active layer of such a polymeric material can be manufactured by means of a CVD process, using a suitable monomer as the starting material, or by spin coating a solution of a soluble, non-conjugated polymeric precursor which is converted into conjugated polymer by a thermal post-treatment.

The international Patent Application WO 92/16023 discloses a soluble, conjugated 2,5-substituted poly(p-phenylene vinylene), namely poly(2-methoxy, 5-(2'-ethylhexyloxy)-p-phenylene vinylene) (MEH-PPV). This conjugated PPV which is substituted with two alkoxy substituents can be dissolved in various organic solvents and provided on a substrate carrying an electrode material by spin coating of a solution. After the solvent has evaporated, without a further thermal post-treatment, an active layer having electroluminescent properties is obtained. A second electrode layer is provided on the active layer. One of the electrode layers is translucent. The structure obtained is that of an LED, which emits light at room temperature in the yellow-orange range of the spectrum.

In practice, however, there is a need for LEDs emitting colours other than yellow-orange at room temperature. In said Patent Application, PPV compounds other than those substituted with two alkoxy groups are not stated nor is it stated in said document which conjugated polymer can be used to manufacture an LED which emits green light.

It is an object of the invention to provide, *inter alia,* an LED whose active layer comprises conjugated 2,5-substituted PPV and emits light in the green range of the spectrum. The invention further aims at providing a simple method of manufacturing such an LED, in which method the active layer is manufactured from a solution of the conjugated PPV, in particular by spin coating, and does not require a thermal post-treatment. A further object of the invention is to provide novel, conjugated 2,5-substituted PPV compounds which are soluble in an organic solvent and which exhibit an electroluminescent effect, so that they can suitably be used in an active layer of an EL device, in particular a LED.

These objects are achieved by a LED as described in the opening paragraph, which is characterized according to the invention in that the poly(p-phenylene vinylene) comprises a repeating unit of the formula 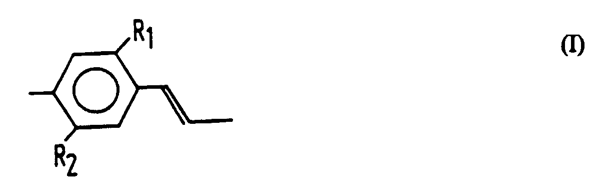 wherein R₁ represents an C₁₀-C₁₂ alkyl group and R₂ represents a C₁-C₄ alkyl group.

Unlike the conjugated MEH-PPV disclosed in the above-mentioned Patent Application WO 92/16023, such a conjugated polymer does not comprise alkoxy groups, but alkyl groups. It has been found that a LED whose active layer comprises a conjugated PPV having a repeating unit in accordance with formula (I) emits green light. In addition, a conjugated polymer having repeating unit (I) can readily be dissolved, namely 1 to 3 wt.%, in many organic solvents, such as toluene, xylene, tetrahydrofuran and mixtures of said solvents, so that the active layer of the LED can be manufactured by, for example, spin coating. The alkyl substituents R₁ and R₂ in formula (I) may be unbranched or branched.

Suitable alkyl substituents R₁ are the 3,7-dimethyl octyl group (C₁₀) the 4,6,6-trimethyl heptyl group (C₁₀), the n-undecyl group (C₁₁) and the n-dodecyl group (C₁₂).

Suitable alkyl substituents R₂ are the methyl group (C₁), the ethyl group (C₂), the propyl group (C₃) and the n-butyl group (C₄).

The use of just these alkyl substituents R₁ and R₂ is based on the observation that alkyl substituents of different size have a positive effect on the solubility of the conjugated PPV. If, per aromatic ring, two equal alkyl substituents are used, for example R₁ = R₂ = C₅-alkyl, the conjugated PPV is practically insoluble in organic solvents. If, per aromatic ring, two equal alkyl substituents R₁ and R₂ are used, which are longer than a C₅ alkyl group, the solubility increases only slowly. The combination of a short alkyl substituent R₂ and a long alkyl substituent R₁ per aromatic ring causes the conjugated PPV to be readily soluble in organic solvents, and the emission of green light is preserved when said PPV is used in an active layer of an LED. It has been found that the use of alkyl substituents R₁, which are longer than C₁₂ alkyl, does not result in a noticeable further increase of the solubility; besides, the quantity of active material per gram of conjugated PPV decreases due to the presence of longer alkyl substituents. Preferably, branched alkyl substituents R₁ are used, because they can be readily dissolved.

It is noted that in European Patent Application EP-A-443861, conjugated 2,5-substituted PPV compounds are mentioned which are substituted with two equal C₁ to C₂₂ alkyl substituents per aromatic ring, for example two methyl, ethyl, heptyl, octyl or lauryl substituents per aromatic ring. It has been found that these compounds exhibit a very poor solubility in organic solvents, so that a spin coated layer of such a polymer becomes inhomogeneous or too thin. The exemplary embodiments in said Patent Applications only give examples of conjugated PPV which is 2,5-substituted with two heptyloxy groups (alkoxy groups comprising 7 C-atoms). It is stated that a LED comprising an active layer of such a polymer emits light in the yellow-orange range of the spectrum. In said European Patent Application there is no indication of the use of two unequal alkyl substituents R₁ and R₂ which have the above-mentioned meaning and by means of which a LED emitting green light can be manufactured.

Dependent upon the method of preparing the conjugated polymer, which method will be specified hereinbelow, the polymer may comprise 5 to 10% of non-conjugated units. It has been found that such non-conjugated units increase the electroluminescent efficiency, which is defined by the number of photons per electron injected into the active layer.

The degree of polymerization n of the conjugated polymer ranges between 10 and 100,000.

The active layer of the conjugated polymer having repeating unit (I) generally has a layer thickness in the range between 50 and 200 nm, in particular between 100 and 200 nm.

The LED structure is provided on a substrate which consists, for example, of glass, quartz glass, ceramic material or synthetic resin. Preferably, a translucent or transparent substrate is used, for example a transparent, flexible foil of synthetic resin. Suitable transparent synthetic resins are, for example, polyimide, polyethylene terephtalate and polytetrafluoroethylene.

The active layer is situated between two electrode layers of electroconductive materials. At least one of said electrode layers must be transparent or transmit the light emitting from the active layer. One of the electrode layers serves as the electrode for the injection of holes into the active layer. The material of this electrode layer has a high work function and is constituted, for example, by a thin layer of gold or silver, or preferably a layer of indium oxide or indium-tin oxide (ITO). Such layers are transparent to the light emitting from the active layer. Particularly ITO is suitable owing to the fact that it has a good electroconductivity and a high degree of transparency. The other electrode layer serves as the electrode for the injection of electrons into the active layer. The material of this layer has a low work function and consists of a layer of, for example, indium, calcium, barium or magnesium. In particular when use is made of the reactive barium it is efficacious to cover said second electroconductive layer with a protective layer, for example, of epoxy or an inert metal.

The invention also relates to novel 2,5 dialkyl-substituted poly(p-phenylene vinylene) compounds which can suitably be used in EL devices, the same or different repeating units of said compounds can be given by the formula 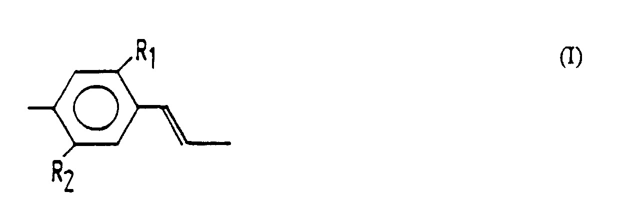 wherein R₁ represents a C₁₀-C₁₂ alkyl group and R₂ represents a C₁-C₄ alkyl group. Examples of suitable alkyl substituents R₁ and R₂ are mentioned hereinabove.

Suitable polymers in accordance with the invention are:
poly[2-methyl-5-(n-dodecyl)-p-phenylene vinylene],
poly[2-methyl-5-(3,7-dimethyl octyl)-p-phenylene vinylene],
poly[2-methyl-5-(4,6,6-trimethyl heptyl)-p-phenylene vinylene].
Said conjugated polymers are readily soluble in organic solvents and emit green light if they are used as an active layer in a LED. The polymers in accordance with the invention may also contain different repeating units (I) by using a mixture of the corresponding monomers in the polymerization reaction which will be elucidated hereinbelow.

The object of providing a method of manufacturing a LED is achieved in accordance with the invention by a method which comprises the following steps:
a. providing a substrate with a first, electroconductive electrode layer,
b. providing said first layer with a solution of a conjugated 2,5 dialkyl-substituted poly(p-phenylene vinylene) having the same or different repeating units in accordance with formula (I), wherein R₁ represents a C₁₀-C₁₂ alkyl group and R₂ represents a C₁-C₄ alkyl group, in a solvent, whereafter the solvent is evaporated, thereby forming the active layer,
c. providing the active layer with a second, electroconductive electrode layer.

For the substrate use can be made of the above-mentioned inorganic substrates, however, preferably use is made of transparent, flexible polymeric substrates, such as substrates of polyimide, polytetrafluoroethylene or polyethylene terephtalate.

The substrate is provided with a, preferably transparent, first electroconductive layer which serves as the electrode layer for the injection of holes into the active layer of conjugated PPV to be provided on said electroconductive layer. For the material of this electrode layer use can be made of the above-mentioned materials, such as a thin layer of gold or silver or a layer of indium oxide or indium-tin oxide (ITO). Particularly ITO is very suitable due to its good electroconductivity and high transparency. This first layer can be provided on the substrate by methods which are known *per se,* such as vacuum evaporation, sputtering or a CVD process.

Subsequently, the active layer of conjugated 2,5-substituted PPV is provided on this first, electroconductive layer. This active layer is provided on the substrate from a solution of the conjugated PPV in a solvent. To provide this layer use can be made of all methods which are known *per se,* but preferably the layer is provided by spin coating. The layer thickness of the active layer generally ranges between 50 and 200 nm and depends, *inter alia,* on the concentration of the polymer in the solvent and on the rotational speed during spin coating. The layer can be provided at room temperature, and apart from the evaporation of the solvent no further thermal post-treatment is required. By virtue thereof, many synthetic resin substrates which are not resistant to high temperatures can be used.

The active layer is provided with a second, electroconductive layer which serves as the electrode layer for the injection of electrons into the active layer. For the material of this electrode layer use can be made of the above-mentioned materials, such as indium, calcium, barium or magnesium. This second layer can alternatively be provided by the above-mentioned methods. In particular when use is made of reactive barium, it is efficacious to cover this second electrode layer with a protective layer, for example, of epoxy or an inert metal.

The invention will be explained in greater detail by means of exemplary embodiments and drawings, in which
Fig. 1 shows the reaction scheme of the preparation of 1,4-dialkylbenzenes,
Fig. 2 shows the reaction scheme of the preparation of 1-(3,7-dimethyl octyl)-4-methylbenzene,
Fig. 3 shows the reaction scheme of the preparation of 1-(4,6,6-trimethyl heptyl)4-methylbenzene,
Fig. 4 shows the reaction scheme of the preparation of bischloromethyl compounds on the basis of 1,4-dialkylbenzenes,
Fig. 5 shows the reaction scheme of the polymerization of bischloromethyl compounds into conjugated 2,5-alkyl-substituted PPV,
Fig. 6 shows the formulas I, II and III of repeating units of conjugated 2,5-alkyl-substituted PPV in accordance with the invention,
Fig. 7 is a diagrammatic cross-sectional view of an EL device, in particular a LED, comprising an active layer of conjugated 2,5-alkyl-substituted PPV in accordance with the invention, and
Fig. 8 shows an I-V and L-V characteristic of a LED manufactured by means of conjugated 2,5-alkyl-substituted PPV in accordance with the invention.

### Exemplary embodiment 1.

The conjugated 2,5-alkyl-substituted PPV compounds are prepared by polymerization of bischloromethyl-dialkylbenzene compounds. Hereinbelow, a description will be given of the preparation of, in succession, 1,4-dialkylbenzene compounds, the corresponding bischloromethyl compounds and the polymerization thereof to form the desired conjugated PPV compounds.

### Preparation of 1,4-dialkylbenzenes.

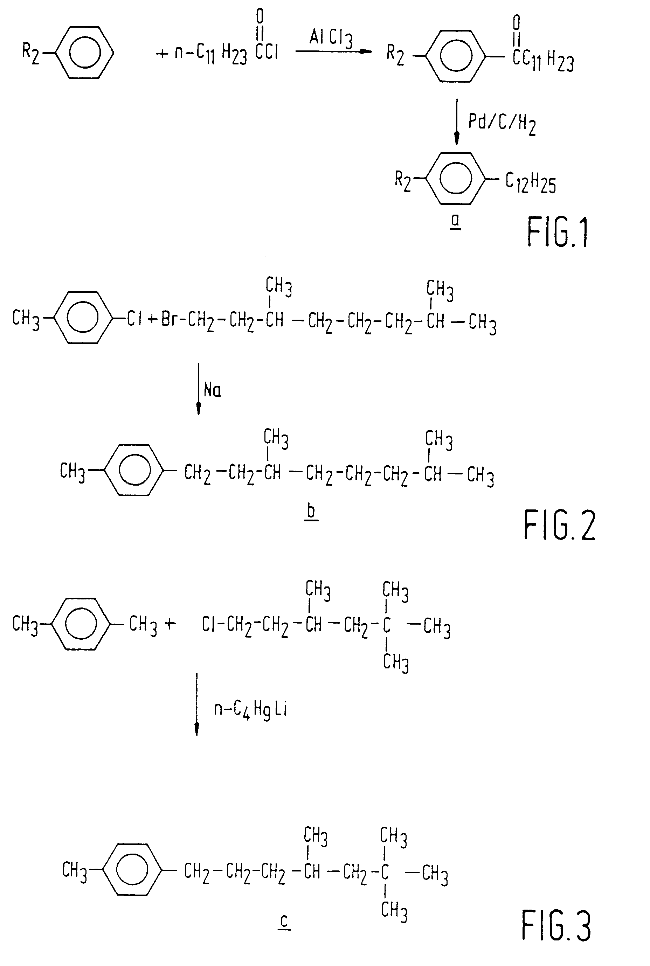

### a. 1-dodecyl-4-methylbenzene; 1-dodecyl-4-ethylbenzene and 1-dodecyl-4-butylbenzene (formula a in Fig. 1).

Fig. 1 shows the reaction scheme of the preparation of 1,4-dialkylbenzenes, wherein R₂ represents, in this example, a CH₃, C₂H₅ or n-C₄H₉ group.

These alkylbenzenes are prepared by means of the following general procedure. A quantity of 110 ml lauroylchloride (0.48 mol) is added, while cooling, to a mixture of AlCl₃ (66 g, 0.5 mol) and 250 ml dichloromethane within 30 minutes. The mixture is stirred at room temperature until all the AlCl₃ has reacted. The solution is cooled by means of ice, whereafter ethylbenzene (74 g, 0.7 mol) is added within 1 hour. The mixture is stirred at room temperature for 18 hours and subsequently poured on ice. The layers are separated after which the aqueous layer is extracted with dichloromethane. The combined organic layers are washed with water, dried and evaporated. The residue is purified by means of bulb-to-bulb distillation, thereby forming a solid, main fraction of 125 g. This solid is hydrogenized with Pd on carbon in 600 ml ethyl acetate until the hydrogen absorption stops and NMR analysis shows that the conversion is complete. After filtration, evaporation and bulb-to-bulb distillation, 114 g colourless oil (0.416 mol, 87%) is obtained which is used in the chloromethylation reaction which will be described hereinbelow.

The preparation of 1-dodecyl-4-butylbenzene takes place in a similar manner. In the case of 1-dodecyl-4-methylbenzene, the intermediate compound dodecanoyl toluene is purified by bulb-to-bulb distillation, followed by recrystallization from methanol.

### b. Preparation of 1-(3,7-dimethyl octyl)-4-methylbenzene (formula b in Fig. 2).

The reaction scheme is shown in Fig. 2. 1-chlorotoluene (155 g, 1.225 mol) is added for 1 hour to a stirred mixture of sodium wire (53,6 g, 2.33 mol) and 650 ml hexane, the temperature being maintained below 30°C by means of cold water. The mixture is subsequently stirred at room temperature for 18 hours, whereafter 221 g (1 mol) 1-bromo-3,7-dimethyl octane (obtained by reacting the, commercially available, corresponding dimethyl octyl alcohol with 47% HBr in water) is added in 15 minutes, the temperature being maintained below 28°C by means of ice. Subsequently, the mixture is placed on a hot-water bath, which is removed when the reaction temperature has reached 45°C. When the temperature of the exothermal reaction has reached 65°C, the mixture is placed on a cold-water bath. After completion of the exothermal reaction, the mixture is refluxed for I hour, whereafter remnants of sodium are destroyed by means of 100 ml ethanol. Subsequently, water is added and the layers are separated. The organic layer is washed with 2 times 500 ml water, dried, evaporated and purified by bulb-to-bulb distillation, thereby forming a main fraction of 149.2 g (0.60 mol, 60%), which fraction is used in the chloromethylation reaction.

### c. Preparation of 1-(4,6,6-trimethyl heptyl)-4-methylbenzene (formula c in Fig. 3).

The reaction scheme is shown in Fig. 3. A quantity of 186 ml tetramethylethylene diamine (TMEDA) is added to 492 ml of 2.5 mol/l n-butyllithium in hexane (1.23 mol), thereby causing an exothermic effect. p-xylene (410 ml, 3.35 mol) is added to the cooled solution, causing an exothermic reaction. The mixture is refluxed for 1 hour and subsequently cooled with ice water. A quantity of 215 g (1.32 mol) 1-chloro-3,5,5-trimethylhexane (prepared by the reaction of the corresponding hexylalcohol with thionylchloride) is added to the mixture for 1.5 hours, the temperature being maintained below 40°C. Subsequently, the mixture is refluxed for 4 hours and then stirred at room temperature for 18 hours. Subsequently, water is added and the layers are separated. The organic layer is washed with water and the aqueous layers are extracted by means of hexane. The organic layers are dried, evaporated and distilled at a temperature of 125°C and a pressure of 0.7 mbar. The yield is 130 g (0.56 mol, 42%).

### Preparation of bischloromethyl compounds.

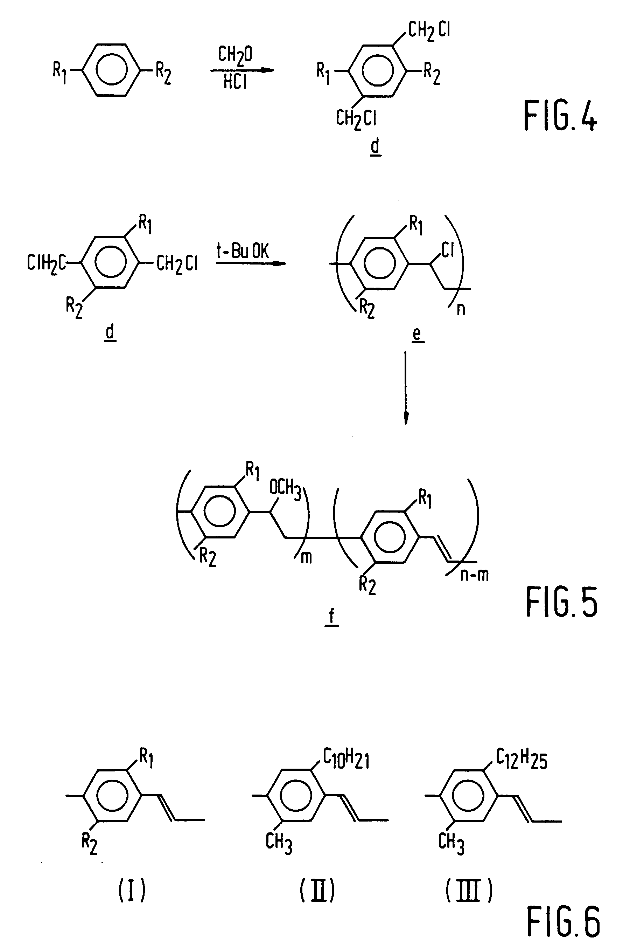

The reaction scheme is shown in Fig. 4. In the following examples, R₂ is a CH₃ group, a C₂H₅ group or an n-C₄H₉ group; R₁ is a dodecyl group, a 3,7-dimethyl octyl group or a 4,6,6-trimethyl heptyl group.

### d. 1,4-bischloromethyl-2-dodecyl-5-methylbenzene (formula d in Fig. 4, wherein R₁ = dodecyl and R₂ = methyl).

A quantity of 100 ml sulphuric acid is added to a mixture of 550 ml acetic acid, 116 g 4-dodecyltoluene (formula a in Fig. 1, wherein R₂ = methyl) and 45 g paraformaldehyde (1.5 mol). The stirred mixture is heated to 80°C, while HCI is bubbled through said mixture for 32 hours. The cooled reaction mixture is extracted with three times 500 ml pentane. The combined pentane layers are washed twice with water, whereafter they are dried and filtered over a small aluminium-oxide column. The filtrate is evaporated and the residue is recrystallized from hexane. This yields 23 g of pure product (64 mmol, 14%).

### e. 1,4-bischloromethyl-2-dodecyl-5-ethylbenzene (formula d in Fig. 4, wherein R₁ = dodecyl and R₂ = ethyl).

The preparation of this compound is analogous to that of the previous compound. The raw product obtained after filtration over aluminium oxide is purified by bulb-to-bulb distillation (170°C, 0.2 mbar) and the distillate is recrystallized from hexane. A quantity of 14.5 g of pure product (39 mmol, 11 %) is obtained from 95 g dodecylethylbenzene (formula a in Fig. 1, wherein R₂ = ethyl).

### f. 1,4-bischloromethyl-2-dodecyl-5-butylbenzene (formula d in Fig. 4, wherein R₁ = dodecyl and R₂ = n-butyl).

The preparation of this compound is analogous to that of the previous compound. The raw product obtained after filtration over aluminium oxide is purified by bulb-to-bulb distillation (170°C, 0.2 mbar) and the distillate is recrystallized from hexane.

A quantity of 23 g of pure product (57.6 mmol, 17%) is obtained from 100 g dodecylbutylbenzene.

### g. 1,4-bischloromethyl-2-(3,7-dimethyl octyl)-5-methylbenzene (formula d in Fig. 4, wherein R₁ = 3,7-dimethyl octyl and R₂ = methyl).

The preparation of this compound is analogous to that of the previous compound. The raw product obtained after filtration over aluminium oxide is purified by bulb-to-bulb distillation (170°C, 0.2 mbar) and the distillate is recrystallized from hexane. A quantity of 55 g of pure product (0.167 mo, 29%) is obtained from 135.8 g 1-(3,7-dimethyl octyl)-4-methylbenzene (formula b in Fig. 2).

### h. 1,4-bischloromethyl-2-(4,6,6-trimethyl heptyl)-5-methylbenzene (formula d in Fig. 4, wherein R₁ = 4,6,6-trimethyl heptyl and R₂ = methyl).

A quantity of 110 ml concentrated sulphuric acid is added to a stirred mixture of 130 g (0.56 mol) 1-(4,6,6-trimethyl heptyl)-4-methylbenzene (formula c in Fig. 3), 300 ml acetic acid, 48 g paraformaldehyde (1.6 mol) and 100 g NaCI (1.71 mol). The mixture is stirred at room temperature for 18 hours, whereafter 30 g NaCI and 30 ml concentrated sulphuric acid are again added. The mixture is subsequently heated to 65°C for 24 hours, whereafter 50 ml concentrated sulphuric acid is added. The mixture is then heated to 60°C for 24 hours. After cooling, 60 g NaCl and 100 ml concentrated hydrochloric acid are added, whereafter the mixture is heated to 75°C for 24 hours. The hot mixture is poured in water, pentane is added and the mixture is filtered over Celite. The layers are separated and the aqueous layer is extracted twice with pentane. The combined pentane layers are washed with water, dried and evaporated. The residue is distilled under a vacuum to separate the monochloromethyl compound (168-172°C, 0.5 mbar) and a mixture of the monochloromethyl and bischloromethyl compound at 172-182°C. The residue is distilled in a bulb tube, thereby forming 97.5 g of the desired compound (0.296 mol, 53%).

### Synthesis of conjugated 2,5-substituted poly(p-phenylene vinylene).

Fig. 5 shows the reaction scheme of the synthesis of conjugated 2,5-alkylsubstituted PPV f, using bischloromethyl compounds d as the starting material. R₁ and R₂ have the above-mentioned meaning. In the following exemplary embodiment, a description is given of the preparation of poly[2-methyl-5-(3,7-dimethyl octyl)-p-phenylene vinylene] in accordance with formula f, wherein R₁ = 3,7-dimethyl octyl and R₂ = methyl. The preparation of the other conjugated polymers takes place in a similar manner.

In nitrogen, 2 g of 2-methyl-5-(3,7-dimethyl octyl)-l,4-bis(chloromethyl) benzene d is dissolved in 400 ml dried tetrahydrofuran (THF) in a three-neck bottle. The solution is cooled to -50°C and a solution of 1.1 equivalent potassium-*t*-butylate (*t*-BuOK) in 100 ml dried THF is slowly added. When all the *t*-BuOK is added, the temperature of the mixture is slowly increased to 0°C. Of said mixture, a quantity of 50% by volume of the THF is removed by distillation and the polymer e obtained is precipitated in methanol. Said precipitate is filtered, washed in methanol and dried at room temperature under a vacuum (0.4 Pa).
The polymer obtained is the non-conjugated chloro-precursor e. To obtain the conjugated polymer, a quantity of 2 g of said precursor e is dissolved in 400 ml cyclohexanone, thereby forming a 0.5 wt.% solution. Dependent upon the desired number of non-conjugated units m, methanol is added to the solution. The addition of for example 10 ml methanol to 400 ml cyclohexanone renders a conjugated polymer f comprising, approximately, a fraction m = 10% of non-conjugated units. If no methanol is added, a fully conjugated polymer f in which m = 0% is obtained. In these formulas, the degree of polymerization n = 10-100,000. A small fraction (m = 5-10%) of non-conjugated units results in an increase of the efficiency of the active layer.
The solution is subsequently heated to 130°C in nitrogen for 12 hours. The solution is then cooled and the polymer f is precipitated in methanol, filtered, washed with methanol and dried under a vacuum. The conjugated polymer f thus obtained, having repeating unit (I) of Fig. 6, can readily be dissolved (up to 3 wt. %) in toluene, THF and xylene.

### Exemplary embodiment 2.

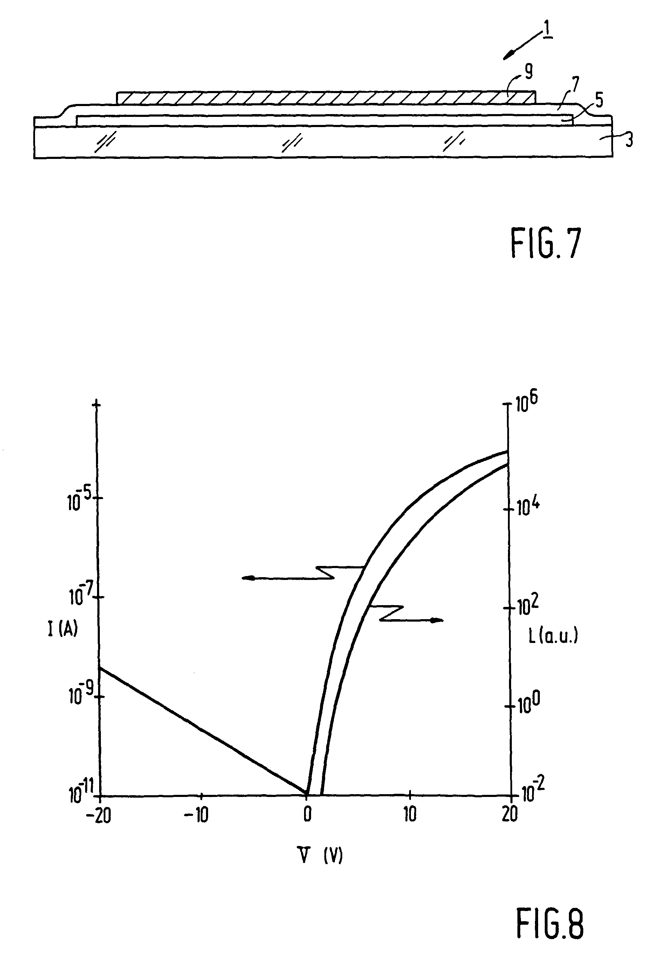

In Fig. 7, reference numeral 1 denotes a schematic representation of a cross-sectional view of a polymeric LED structure. A transparent indium-tin oxide layer (ITO) 5 having a surface resistance below 20 Ω/square is sputtered on to a glass substrate 3. This layer 5 serves as the electrode layer for injecting holes in the active layer 7 which is to be subsequently provided and which consists of conjugated PPV having a repeating unit (I) (Fig. 6). This active layer has a thickness of 150 nm and is manufactured by spin coating an 1-3 wt. % solution of a conjugated 2,5-alkyl-substituted PPV in accordance with the invention. For the solvent use can be made of toluene, xylene, THF or mixtures of said solvents. A calcium layer 9 is provided on the active layer 7 by evaporation at a pressure below 2.10⁻⁴ Pa. The calcium layer 9 has a layer thickness of 250 nm and serves as the electrode for injecting electrons into the active layer 7. The size of the polymeric LED is 1 cm².

The two electrode layers 5 and 9 are connected to a direct-current source, the calcium electrode 9 being connected to earth. The polymeric film 7 of conjugated PPV in accordance with the invention always emits homogeneous, green light which is clearly visible under daylight circumstances. In the completely conjugated state (fraction m = 0%), an efficiency of 0.2% is attained, *i.e*. two photons are generated per 1000 electrons injected into the active layer.

Fig. 8 shows the characteristic of the LED obtained, the current I, in ampere, being plotted as a function of the applied voltage V, in volts, between the electrodes. In addition, the quantity of light L (electroluminescence) is shown in arbitrary units (a.u.) as a function of the voltage V. In the example, poly[2-methyl-5-(3,7-dimethyl octyl)-p-phenylene vinylene] (repeating unit formula II of Fig. 6) is used as the active layer. The LED emits green light in the range between 480 and 650 nm, with maximum emission around 530 nm.

A LED having poly[2-methyl-5-(n-dodecyl)-p-phenylene vinylene] (repeating unit formula III of Fig. 6) as the active layer is manufactured in the same manner. Said LED emits green light in the range between 480 and 650 nm, with maximum emission around 560 nm.

The method in accordance with the invention enables polymeric LEDs having a large surface area to be manufactured in a simple manner by means of spin coating, the active layer of said LEDs being constituted by a conjugated 2,5-alkyl-substituted PPV. The LEDs obtained emit green light. The method can very suitably be used for the manufacture of LEDs on large, flexible substrate surfaces.

## Claims

1. A light-emitting diode comprising an active layer which contains conjugated 2,5 dialkyl-substituted poly(p-phenylene vinylene) and which layer is situated between two electrode layers, at least one of which is translucent, characterized in that the poly(p-phenylene vinylene) comprises the same or different repeating units of the formula 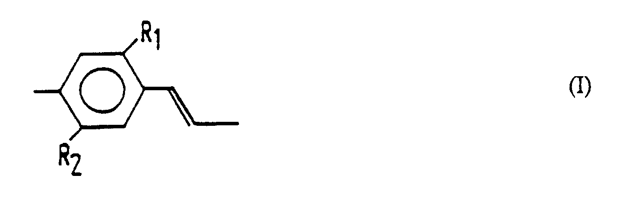 wherein R₁ represents a C₁₀-C₁₂ alkyl group and R₂ represents a C₁-C₄ alkyl group.

2. A light-emitting diode as claimed in Claim 1, characterized in that R₁ represents a 3,7-dimethyl octyl group and R₂ represents a methyl group.

3. A light-emitting diode as claimed in Claim 1, characterized in that R₁ represents an n-dodecyl group and R₂ represents a methyl group.

4. A light-emitting diode as claimed in Claim 1, characterized in that R₁ represents an n-dodecyl group and R₂ represents an ethyl group.

5. A light-emitting diode as claimed in Claim 1, characterized in that R₁ represents an n-dodecyl group and R₂ represents an n-butyl group.

6. A light-emitting diode as claimed in Claim 1, characterized in that R₁ represents a 4,6,6-trimethyl heptyl group and R₂ represents a methyl group.

7. A conjugated 2,5 dialkyl-substituted poly(p-phenylene vinylene) comprising the same or different repeating units of the formula 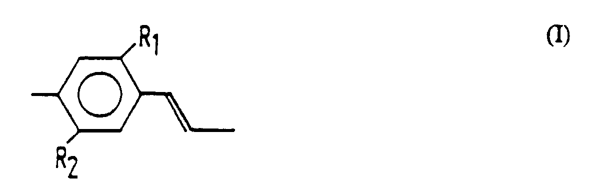 wherein R₁ represents a C₁₀-C₁₂ alkyl group and R₂ represents a C₁-C₄ alkyl group.

8. A conjugated 2,5-substituted poly(p-phenylene vinylene) as claimed in Claim 7, wherein R₁ is a substituent selected from the group formed by n-dodecyl, 3,7-dimethyl octyl and 4,6,6-trimethyl heptyl and R₂ represents a methyl group.

9. A method of manufacturing a light-emitting diode as claimed in Claim 1, which method comprises the following steps:
a. providing a substrate with a first, electroconductive electrode layer,
b. providing said first layer with a solution of a conjugated 2,5 dialkyl-substituted poly(p-phenylene vinylene) having the same or different repeating units in accordance with formula (I), wherein R₁ represents a C₁₀-C₁₂ alkyl group and R₂ represents a C₁-C₄ alkyl group, in a solvent, whereafter the solvent is evaporated, thereby forming the active layer,
c. providing the active layer with a second, electroconductive electrode layer.

## Patentansprüche

1. Leuchtdiode mit einer aktiven Schicht, die konjugiertes 2,5-dialkyl-substituiertes Poly(p-Phenylen-Vinylen) aufweist und wobei diese Schicht sich zwischen zwei Elektrodenschichten befindet, von denen mindestens eine lichtdurch- lässig ist, dadurch gekennzeichnet, daß das Poly(p-Phenylen-Vinylen) eine Wiederholungseinheit aufweist mit der Formel: 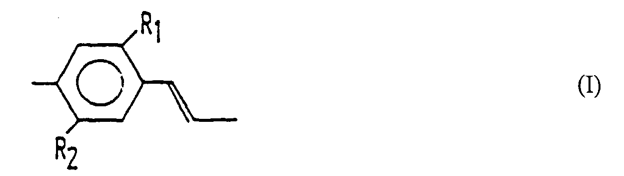 worin R₁ eine C₁₀-C₁₂-Alkylgruppe und R₂ eine C₁-C₄-Alkylgruppe darstellt.

2. Leuchtdiode nach Anspruch 1, dadurch gekennzeichnet, daß R₁ eine 3,7-Dimethyloctylgruppe darstellt und daß R₂ eine Methylgruppe darstellt.

3. Leuchtdiode nach Anspruch 1, dadurch gekennzeichnet, daß R₁ eine n-Dodecyl-Gruppe darstellt und daß R₂ eine Methylgruppe darstellt.

4. Leuchtdiode nach Anspruch 1, dadurch gekennzeichnet, daß R₁ eine n-Dodecylgruppe darstellt und daß R₂ eine Ethylgruppe darstellt.

5. Leuchtdiode nach Anspruch 1, dadurch gekennzeichnet, daß R₁ eine n-Dodecylgruppe darstellt und daß R₂ eine n-Butylgruppe darstellt.

6. Leuchtdiode nach Anspruch 1, dadurch gekennzeichnet, daß R₁ eine 4,6,6-Trimethylheptylgrppe darstellt und das R₂ eine Methylgruppe darstellt.

7. Konjugiertes 2,5-Dialkylsubstituiertes Poly(p-Phenylen-Vinylen) mit derselben oder einer anderen Wiederholungseinheit nach der Formel: 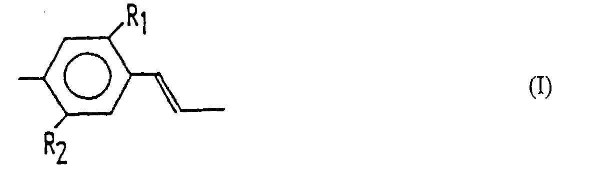 wobei R₁ eine C₁₀-C₁₂-Alkylgruppe und R₂ eine C₁-C₄-Alkylgruppe darstellt.

8. Konjugiertes 2,5-Dialkylsubstituiertes Poly(p-Phenylen-Vinylen) nach Anspruch 7, wobei R₁ ein Substituent, selektiert aus der Gruppe, gebildet durch n-Dodecyl, 3,7-Dimethyloctyl und 4,6,6-Trimethylheptyl und R₂ eine Methylgrup[pe darstellt.

9. Verfahren zum Herstellen einer Leuchtdiode nach Anspruch 1, wobei dieses Verfahren die nachfolgenden Verfahrensschritte umfaßt:
a. das Anbringen einer ersten elektrisch leitenden Elektrodenschicht auf einem Substrat,
b. das Anbringen einer Lösung eines konjugierten 2,5-Dialkyl-substituierten Poly(p-Phenylen-Vinylens) mit derselben oder einer anderen Wiederholungseinheit nach der Formel (I) auf der ersten Schicht, wobei R₁ eine C₁₀-C₁₂-Alkylgruppe darstellt und R₂ eine C₁-C₄-Alkylgruppe in einem Lösungsmittel, wonach das Lösungsmittel unter Bildung der aktiven Schicht zum Verdampfen gebarcht wird,
c. das Anbringen einer zweiten elektrisch leitenden Elektrodenschicht auf der aktiven Schicht.

## Revendications

1. Diode électroluminescente comportant une couche active qui contient du poly(p-phénylène-vinylène) conjugué substitué avec du dialcoyle en position 2 et en position 5, et qui se situe entre deux couches d'électrode dont au moins une est translucide, caractérisée en ce que le poly(p-phénylène-vinylène) comporte les mêmes ou des unités de répétition différentes de la formule 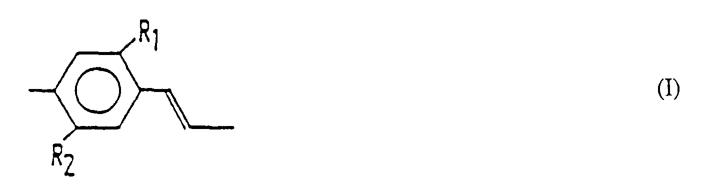 où R₁ représente un groupe d'alcoyle C₁₀-C₁₂ et R₂ représente un groupe d'alcoyle C₁-C₄.

2. Diode électroluminescente selon la revendication 1, caractérisée en ce que R₁ représente un groupe de 3,7-diméthyloctyle et R₂ représente un groupe de méthyle.

3. Diode électroluminescente selon la revendication 1, caractérisée en ce que R₁ représente un groupe de n-dodécyle et R₂ représente un groupe de méthyle.

4. Diode électroluminescente selon la revendication 1, caractérisée en ce que R₁ représente un groupe de n-dodécyle et R₂ représente un groupe d'éthyle.

5. Diode électroluminescente selon la revendication 1, caractérisée en ce que R₁ représente un groupe de n-dodécyle et R₂ représente un groupe de n-butyle.

6. Diode électroluminescente selon la revendication 1, caractérisée en ce que R₁ représente un groupe de 4,6,6-triméthylheptyle et R₂ représente un groupe de méthyle.

7. Poly(p-phénylène-vinylène) conjugué substitué avec du dialcoyle en position 2 et en position 5 comportant les mêmes ou des unités de répétition différentes de la formule 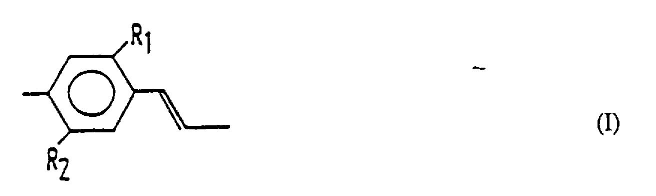 où R₁ représente un groupe d'alcoyle C₁₀-C₁₂ et R₂ représente un groupe d'alcoyle C₁-C₄.

8. Poly(p-phénylène-vinylène) conjugué substitué en position 2 et en position 5 selon la revendication 7 où R₁ est un substituant choisi parmi le groupe formé par du n-dodécyle, du 3,7-diméthyloctyle et du 4,6,6-triméthylheptyle et où R₂ représente un groupe de méthyle.

9. Procédé pour fabriquer une diode électroluminescente selon la revendication 1, ledit procédé comportant les étapes suivantes:
a. munir un substrat d'une première couche d'électrode électroconductrice,
b. munir ladite première couche d'une solution constituée d'un poly(p-phénylène-vinylène) conjugué substitué avec du dialcoyle en position 2 et en position 5 présentant les mêmes ou des unités de répétition différentes conformes à la formule (I) où R₁ représente un groupe d'alcoyle C₁₀-C₁₂ et R₂ représente un groupe d'alcoyle C₁-C₄ dans un solvant, après quoi le solvant est évaporé, de ce fait constituant la couche active,
c. munir la couche active d'une deuxième couche d'électrode électroconductrice.
